# EUROPEAN PATENT APPLICATION

(11) **EP 3 757 584 A1**
(43) Date of publication of application: **30.12.2020**
(21) Application number: 19756816.5
(22) Date of filing: 20.02.2019
(51) Int. Cl.: G01R 31/12, G01R 35/00, G01R 29/24

(54) **METHOD FOR ASSESSING AND QUALIFYING THE FUNCTIONAL FEATURES OF INSTRUMENTS FOR MEASUREMENT AND DIAGNOSIS OF PARTIAL DISCHARGES AND FACILITY FOR GENERATING SERIES OF REFERENCE PULSES OF PARTIAL DISCHARGES**

(30) Priority: 20.02.2018 ES 201800043
(71) Applicant: FUNDACION PARA EL FOMENTO DE LA INNOVACION INDUSTRIAL, 28006 Madrid (ES)
(72) Inventor: GARNACHO VECINO, Fernando, 28043 MADRID (ES); ALVAREZ GOMEZ, Fernando, 28915 MADRID (ES); KHAMLICHI EL KHAMLICHI, Abderrahim, 28025 MADRID (ES)
(74) Representative: Baños Treceño, Valentín
(86) International application number: PCT/ES2019/070096
(87) International publication number: WO 2019/162551

(57) **Abstract**

Method for evaluating and qualifying of the functional characteristics of PD measuring and diagnostic instruments, which comprises the following stages:
- generation (1) either from a scale HV testing setup (100) or from an arbritary function generator of at least one PD reference pulse test series characteristic of a type of electrical defects representative of HV grids,
- generation of at least one electrical noise signal (9),
- superposition (14) without galvanic connection of one or more of the series of PD reference pulses generated corresponding to a specific functional characteristic of the measuring and diagnostic instrument for discrete values of charge and of the generated electrical noise signal(s), and
- Evaluation and qualification (15) of said functional characteristic of the measuring and diagnostic instrument, supplying the superposition of signals and reading to compare with the expected values.

## Description

### INVENTION OBJECT

The present invention relates to a method for evaluating and qualifying the functional characteristics of partial discharge measuring and diagnostic instruments, and an setting-up for generating series of reference pulses of partial discharges to be used in the method to evaluate the functional characteristics of the measuring instruments.

### BACKGROUND OF THE INVENTION

One of the main problems presented by high voltage (hereinafter HV) insulations is the appearance of unforeseen failures caused by defects in the dielectrics of the different elements that electrically isolate the HV parts.

Under normal operating conditions, the insulations of HV electrical installations are subjected to electrical, mechanical, thermal and environmental stresses. These stresses tend to age and degrade the dielectrics, causing defects whose final evolution leads to insulation failure and consequently to a power arc with strong destructive capacity. It is also possible the appearance of defects in the insulation due to failures in the manufacturing and assembly processes of the elements that make up the facilities.

Partial discharges (hereinafter, PD) can be considered as a relevant indicator of the health condition of insulations. PDs are, in general, a partial short-circuit of an insulation and they are characteristically pulsating signals that are manifested as short-duration current pulses. The current pulses of a PD right at the point where they are produced have a duration of units or tens of nanoseconds, but as they propagate through the grid, they are attenuated and distorted, losing the higher frequency components, presenting a duration around 1 microsecond. The quantity generally used to quantify these pulses is their charge, which corresponds to the area of the current signal in the time domain.

The PD measurement allows detecting defects in insulating elements. Today, PD measurement has become one of the main diagnostic methods used in preventive maintenance and maintenance based on the condition of HV electrical elements. Among the main advantages of PD measurements, the following can be highlighted:
- The ability to detect anomalies in the insulating elements of HV equipment as a result of factory defects, failures in the assembly processes of the facilities or the aging of the insulation itself, and
- The possibility of carrying out measurements with the facilities in service (online measurements), which is an important advantage to carry out the proper maintenance of your assets.

PD activity can be detected by applying electromagnetic, acoustic, optical measuring methods, or by chemical analysis of by-products derived from discharges. Electromagnetic methods are the most widely used due to their versatility and effectiveness. PD measurement using electromagnetic detection techniques is currently carried out in laboratories applying the normative method according to the IEC 60270 standard (also called conventional method), or in the field using non-conventional methods, offered in the IEC technical specification IEC 62478. When the normative method is applied, measurements are made in bandwidths below 1 MHz, while when non-conventional methods are applied, they are usually measured in bands comprised in high frequency ranges (HF≤30 MHz), from very high frequency (30 MHz <VHF≤300 MHz) and ultra high frequency (300 MHz <UHF≤3 GHz).

When electromagnetic detection methods are used in alternating current grids, the result of the PD measurements is generally represented by phase resolved PD patterns (PRPD), which show the amplitude of the pulses and the time instants in which they were generated versus the reference voltage applied to the insulation. These patterns are related to the nature of the defect types, so through their analysis, it is possible to identify the type of insulation defect where a degradation process by DP is generated.

There are multiple measuring instruments on the market that have signal processing tools to eliminate noise, locate the position where PD are generated along an isolated line or in a piece of equipment, separate the sources of PD generation and identify the causes that produce them. Consequently, it is necessary to evaluate the ability of the measuring and diagnostic instruments in order to check if they are more or less effective versus the indicated functionalities.

The main problems faced by PD analyst technicians of PD measuremenst are as follows:
1) Sensitivity problem in the measurement of PD pulses versus electrical noise signals.
2) Location problem of defects that generate PD.
3) Problem of determining the location of the affected element in the event that the defect of PD generation is close to the interconnection boundary between two HV equipment.
4) Separation problem of different PD sources corresponding to different defects produced in the same equipment.
5) Identification problem of the physical cause that generates the defect associated with each of the PD sources.

In the sensitivity problem in the measurement versus electrical noise or electromagnetic interference masks the PD measurement. Commercial equipment has analogical filters, digital filters, selective filters or other signal processing filters that try to eliminate electrical noise, keeping the current signal of the generated PD in the defects as intact as possible. A filter is said to be the more effective the more capable it is of removing electrical noise with minimal attenuation and distortion of the PD signals. However, the PD pulse signal always suffers some attenuation and distortion after filtering, so it is important to evaluate the PD signal loss after filtering.

In the location problem of PD sources, when the generated PDs in a source propagate along a cable (whose length is known) in a grid, it is necessary to identify the distance at which said source is from the end where the sensor, connected to the measuring instrument to be evaluated, is placed.

In the problem of determining the location of the affected element in the event that the defect of PD generation is at the vicinity of a border point, between two elements of the grid (eg in a cable and a power transformer), it is necessary to identify in which of the two interconnected elements is the source of partial discharges that produces the defect.

In the separation problem of sources producing DP located in the same equipment, this separation is obviously necessary to detect all the present defects, since there are sources producing PD that can hide others.

In the identification problem of the physical cause that generates a defect, this identification is obviously necessary, since the type of defect associated with each source of PD is being sought.

PD measuring and diagnostic instruments try to reliably solve the aforementioned problems, incorporating funcionalities or tools that are capable of evaluating certain functional characteristics to solve each of these problems. Therefore, this invention tries to evaluate if the measuring and diagnostic instruments are more or less effective versus these challenges.

Precisely to evaluate the reliability of PD measuring and diagnostic instruments versus the indicated problems, the inventor knows the following useful background for the evaluation of PD measuring instruments:
**1) PD pulse calibrator according to IEC 60270** (see reference [1] in description table). It is referred in the document: International Standard IEC 60270. High Voltage Test Techniques - Partial Discharge Measurements, 3rd.; International Electrotechnical Commission: Geneva, Switzerland, 2000. The solution proposed by the IEC 60270 standard is to generate PD pulses by discharging a previously charged Co capacitor using a direct voltage Uo so that it accumulates a stored charge of Qo=CoxUo. Charges and discharges are normally carried out in a periodic time interval associated with the period of the alternating voltage of the grid. The discharge of the capacitor is carried out suddenly by closing a mercury switch or similar so that it does not bounce and its closing time is negligible.
   This solution has the following drawbacks:
   a) It does not generate a series of pulses representative of a defect, only periodic pulses of the same selected amplitude. It does not allow generating a sequence of two consecutive pulses in a predefined time to simulate a real sequence of PD pulses.
   b) It does not allow the generation of any superimposed noise signal to be able to analyze the sensitivity versus electrical noise.
   c) It does not allow simulating the propagation of PDs through a cable.
   d) It does not allow any PD source to be located on either side of a connection boundary between two equipment.
   e) It does not allow the generation of different PD sources to analyze the source separation ability of a measuring instrument.
**2) PD generator in a power transformer model** (see reference [2] in the description table). It is referred in the document: Transformer partial discharge defects simulation device, CN205720535 (U) - 2016-11-23. This is a model of an oil transformer with transformer windings incorporating different types of PD defects of a power transformer. The disadvantages of this solution compared to the one presented are shown in Table 1.
   This solution has the following drawbacks:
   a) Although transformer defects are generated, it is not specified how they have been carried out or the operating ranges.
   b) It does not allow the generation of any superimposed noise signal to be able to analyze the sensitivity versus electrical noise.
   c) It does not allow simulating the propagation of PDs through a cable.
   d) It does not allow any PD source to be located on either side of a connection boundary between two equipment.
   e) The possibility of generating different PD sources simultaneously to analyze the source separation ability of a measuring instrument is not considered.
**3) PD generator in a SF6 isolated model** (see reference [3] in the description table). It is referred in the document: A as discharge room for gas - insulated electrical equipment partial discharge multisource defects, CN205749796 (U) - 2016-11-30. It is a model that generates only DP in unspecified defects that occur in SF6 isolated equipment.
   This solution has the following drawbacks:
   a) The defects generated are not specified.
   b) It does not allow the generation of any superimposed noise signal to be able to analyze the sensitivity versus electrical noise.
   c) It does not allow simulating the propagation of PDs through a cable.
   d) It does not allow one or another PD source to be located on either side of a connection boundary between two equipment.
   e) The possibility of generating different PD sources simultaneously to analyze the source separation ability of a measuring instrument is not considered.
**4) PD generator in a SF6 isolated model** (see reference [4] in the description table). It is referred in the document: Inside multiple partial discharge's of GIS analogue means, CN205643609 (U) - 2016-10-12. It is a model that generates PD in defects that occur in SF6-isolated equipment.
   This solution has the following drawbacks:
   a) Although defects are generated in SF6, the operating ranges are very high (110 kV). Furthermore, the generation of PD with direct voltage is not considered.
   b) It does not allow the generation of any superimposed noise signal to be able to analyze the sensitivity versus electrical noise.
   c) It does not allow simulating the propagation of PDs through a cable.
   d) It does not allow one or another PD source to be located on either side of a connection boundary between two equipment.
   e) The possibility of generating different PD sources simultaneously to analyze the source separation ability of a measuring instrument is not considered.
**5) Synthetic PD generator** (see reference [5] in the description table). It is referred in the document: Partial discharge signal generator, CN203241526 (U) - 2013-10-16. It is an electronic device that synthetically generates four types of PD pulses without specifying the fundamentals of generation.
   This solution has the following drawbacks:
   a) The ability to generate a series of representative pulses is not specified. The ability to generate a sequence of consecutive pulses in a predefined time to simulate an actual sequence of PD pulses is also not specified.
   b) It does not allow the generation of any superimposed noise signal to be able to analyze the sensitivity versus electrical noise.
   c) It does not allow simulating the propagation of PDs through a cable.
   d) It does not allow any PD source to be located on either side of a connection boundary between two equipment.
   e) The ability to generate different PD sources simultaneously to analyze the source separation ability of a measuring instrument is not specified.
**6) PD signal generator by capacitor discharge** (see reference [6] in the description table). It is referred in the document: Integrated Controllable Partial Discharge Instrument Pulse Signal Generator, CN105044640 (A) - 2015-11-11. It is a programmable electronic device connected to a capacitor to generate PD-type waveforms without specifying the fundamentals of generation.
   This solution has the following drawbacks:
   a) It is not possible to generate a series of pulses representative of a defect. The ability to generate a sequence of consecutive pulses in a predefined time to simulate an actual sequence of PD pulses is also not specified.
   b) It does not allow the generation of any superimposed noise signal to be able to analyze the sensitivity versus electrical noise.
   c) It does not allow simulating the propagation of PDs through a cable.
   d) It does not allow any PD source to be located on either side of a connection boundary between two equipment.
   e) It is not possible to generate different PD sources simultaneously to analyze the source separation ability of a measuring instrument.
**7) PD pulse generator** (see reference [7] in the description table). It is referred in the document: Partial discharge pulse generator JPH1038946 (A) - 1998-02-13. It is an artificial pulse generator with characteristics similar to PD.
   This solution has the following drawbacks:
   a) It does not generate a series of pulses representative of a defect, only artificial pulses with characteristics similar to PD. Generating a sequence of two consecutive pulses in a predefined time to simulate a real sequence of PD pulses is not considered.
   b) It does not allow the generation of any overlapping noise signal in order to analyze the sensitivity versus electrical noise.
   c) It does not allow to simulate the propagation of PD through a cable.
   d) It does not allow any PD source to be located on either side of a connection boundary between two equipment.
   e) It does not allow the generation of different PD sources to analyze the source separation capacity of a measuring instrument.
**8) Test platform to measure multiple PD sources** (see reference [8] in description table). It is collected in the document: A new design of a test platform to test multiple sources of partial discharges, A. Rodrigo Mor et al. Electric energy and energy systems, Elsevier, 2017. It is a test platform where sources of PD generation are found.
   This solution has the following drawbacks:
   a) Although PD pulses are generated in six types of defects, these are rigidly fixed and subsequently reproducing PD synthetically is not considered. Neither does the generation of PD with direct voltage.
   b) It does not allow the generation of any overlapping noise signal in order to analyze the sensitivity versus electrical noise.
   c) It does not allow simulating the propagation of PDs through a cable.
   d) It does not allow any PD source to be located on either side of a connection boundary between two equipment.
   e) Although it is possible to generate different PD sources simultaneously to analyze the source separation ability of a measuring instrument, it does not allow the same test with defects to be reproduced analogically without the need to generate HV.

### DESCRIPTION OF THE INVENTION

The method for evaluating and qualifying the functional characteristics of PD measuring and diagnostic instruments allows such evaluation and qualification to be carried out with full reliability in the face measuring sensitivity problems of PD-type pulse versus electrical noise signals, location of defects that generate PD, location of the affected element in the event that the defect of PD generation is close to the interconnection boundary between two HV equipment, separation of different PD sources corresponding to different defects produced in the same equipment or facility and identification of each of the PD source with the physical cause that originates it, since it incorporates all the following operations:
- Ability to generate PD pulses representative of type defects in electrical insulation, whether in alternating or direct current.
- Ability to superimpose electrical noise on the generated PD pulses.
- Ability to generate pulses delayed in time to simulate their propagation through the grid.
- Ability to have PD sources on either side of a border between two HV equipment, and
- Ability to generate several type defects simultaneously.

This enables to evaluate fundamental functional characteristics of PD diagnostic and measuring instruments, including but not limited to:
- detection sensitivity of a defect type versus noise,
- ability to associate a PD pulse generator source with a type of electrical defect versus electrical noise conditions,
- ability to separate different sources of PD generation measured with a single sensor versus electrical noise conditions,
- ability to identify where the PD pulses come from when they are detected by a single sensor located at the border ground connection between two devices, versus electrical noise conditions, and
- location error expressed in meters of a PD source along a cable measured with one or two high-frequency sensors, versus electrical noise conditions.

According to the invention, the method in its most elementary version comprises the following stages:
- generation from a scale testing set-up, or optionally from a synthetic artificial pulse generator obtained from said scale testing set-up, of a test series composed of at least one series of PD reference pulses representative of a electrical defect type representative of HV grids, (in this document the HV testing set-up is a model of reduced dimensions and a few kilovolts, and the synthetic generator is a D/A converter that produces series of PD pulses that characterizes a specific defect - in a insulation, false contact, floating particles, etc. - to be simulated in said setting-up).
- generation of at least one electrical noise signal,
- superposition by electromagnetic coupling without galvanic connection of one or more of the generated PD reference pulse series corresponding to a specific functional characteristic of the measuring and diagnostic instrument for discrete values of charge and of the generated electrical noise signal(s), and
- evaluation and qualification of said functional characteristic of the measuring and diagnostic instrument by supplying it with the superposition of signals to obtain the reading and the diagnostic result of said instrument and with the expected values.

In this way, and since the PD associated with defects and noise signals are known, we know in advance the reading that the instrument should give, and it will be possible to check if the reading coincides with what is expected.

Indicate that for the optional synthetic generation of artificial pulses, an optimized record, saved in memory, of the PD pulse series, of the simulation carried out in the HV testing set-up, is used. recording that is made with high time definition (5 ns or 10 ns) and high resolution (16 bits); only PD pulses are saved, rejecting data that does not contain PD pulses (data considered as electrical noise). To this end, the start and end of each pulse is identified and the starting instant of each pulse is also saved.

It should also be noted that for the preparation of a testing series the concatenation by repetition of shorter reference PD pulse series is required, as many times as necessary to complete a longer series duration, so that all the series are combined so that they can be playedback simultaneously in testing time.

And all this according to the invention setting-up, which in its equally most elementary version comprises:
- an adjustable AC or DC HV generation module (a few kilovolts is enough) to simulate the power supply of the grid.
- a power cable of known characteristics that is connected to said voltage generation module,
- a cabin module connected to the power cable, comprising an HV plate isolated from a metallic enclosure by a capacitor, to simulate the capacitance of the insulations with respect to the metallicenclosure of a facility,
- an electrical grid module, comprising an isolated HV cable to simulate a power cable from the transmission or distribution grid connected to the cabin module and a capacitor, to simulate the continuity of the isolated lines of the grid,
- a module of a set of plug-in cells with type defects for the generation of series of reference PD pulses, which is coupled to the HV plate of the "cabin module", and which comprises plug-in cells with a type defect, connected all of them to the HV plate, but leaving the connection of their grounding parts of each one free,
- a module for direct measurement of the pulses of the PD series at the source where they occur,
- a module to measure the charge of the pulse series by using the normative method (IEC 60270) and by using a high-frequency current transformer,
- a module for the generation and measurement of electrical noise signals,
- a module for superimposing the generated electrical noise signal with the generated series of reference PD pulses to apply said superposition to the measuring and diagnostic instrument.

Optionally, for the synthetic generation of the artificial PD pulses, the setting-up can also comprise a module for digital recording, optimized in memory, only of the PD type pulses and analogical playback by means of a D/A convert and an amplifier.

In addition to being able to evaluate all the fundamental functional characteristics of PD measuring and diagnostic instruments, which was the initially sought objective, due to the technological gap of the existing solutions, the following initially unexpected additional advantages have been found:
- record (instead of reference PD pulses) the PD pulses that occur in a real HV installation in service, with high definition (eg 5 ns or 10 ns) and high resolution (16 bits), to be able to reproduce them analogically and faithfully at any later time. This makes it possible for any PD diagnostic instrument on the current or future market could analyze PD measurements to diagnose a complicated or critical defect in a singular installation, without having to travel to the installation where they occurred (for example, in security rooms of a nuclear power plant, electronics from space facilities in which PD measurements for printed circuit boards are also beginning to be used).
- as the HV testing set-up is a scaled-down installation of a few kilovolts (for example 12 KV), it is economical and easy to use for training students and researchers,
- The set-up and the procedure also serves to check the sensitivity of the measuring instrument to be used onsite before a commisioning test of a large installation (eg "off-shore" wind installation, a submarine cable that evacuates the energy from a group of wind turbines in high seas).
- the setting-up and the procedure can be configured to analyze any functional characteristic that may be of interest in the future, since all of them will be able to be parameterized based on the operability of the invention; indeed, among others, a new cell/test tube can be developed/invented that includes a new representative type defect (disease) that may appear in HV facilities or in other technical areas (electronics), which would only need to include the new pluggable cell in the cell set module with type defects.
- the recording of series of PD pulses identifying type defects, for the purposes of standardization and technological advance in the detection of types of defects, the problem of the need to use large data capacities of analog storage media was overcome by means of complementary solutions based on in the memory optimization method, saving only the PD pulses.
- optional possibility to record and measure PD produced with HV Direct Current, so that a diagnosis can be made, since it is known that in these normative tests, lasting hours, PD pulses due to an internal defect are limited in number (normally small) and amplitude, which is very difficult to know due to the presence of electrical noise during the test. All these functions: record, measure and determine only the PD pulses rejecting the noise that is produced in the test using the method with the HV setting-up, and then is easily reproduce, which will greatly facilitate accepting or rejecting normative compliance of an instrument or installation under test.

Below is a table that summarizes the antecedent solutions and their offered capabilities compared to those necessary to be able to reliably evaluation a PD measuring and diagnostic instrument versus the problems indicated above, and their confrontation with the capabilities of the invention to facilitate appreciation of the advantages of the invention. Various indications regarding these capabilities are also included at the bottom of the table.

| **Capabilities in known solutions versus capabilities of the invention** | | **i. Ability to generate PD pulses representative of electrical defects** | **ii. Ability to superimpose electrical noise on the generated PD pulses** | **iii. Ability to generate pulses delayed in time to simulate their propagation through the cable grid.** | **iv. Ability to have PD sources on either side of a border between two HV equipment** | **v. Ability to generate several type defects simultaneously** |
|---|---|---|---|---|---|---|
| 1) | IEC 60270 Calibrator | NO | NO | NO | NO | NO |
| 2) | PD generator in a model of a power transformer | YES Although it is not specified any embodiment or the operating ranges | NO | NO | NO | NO |
| 3) | PD generator in a SF6 model | Generated defects are nos spicified | NO | NO | NO | NO |
| 4) | PD generator in a SF6 model. | YES Although the generation ranges are very high and it works only in AC | NO | NO | NO | It is not considered |
| 5) | Synthetic Generator of PD pulses | NO | NO | NO | NO | NO |
| 6) | PD Generator by cpacitor discharge | NO | NO | NO | NO | NO |
| 7) | Generator of PD pulses | NO | NO | NO | NO | NO |
| 8) | Testing tesing setting-up to measure multiple PD sources | YES Only for HVAC generator and 6 fixed defects | NO | NO | NO | SI |
| | | YES | YES | YES | YES | YES |

| | | | | | | |
|---|---|---|---|---|---|---|
| 9) | New proposed invention | using HV generator or using a synthetic generator for AC and DC. | | | | |

Clarifying notes regarding the indicated capabilities:
i. **Ability to generate representative PD pulses of type defects in electrical insulation,** which can occur: either through a reference testing set-up with plug-in and interchangeable cells designed with type defects by HV application and in ranges of a few kilovolts or through a digital/analog player-back of PD pulses that have been previously recorded in digital files by a high-speed sampling digital recorder, during an HV test using the reference testing set-up.
ii. **Ability to superimpose electrical noise on representative PD pulses of type defects in insulations:** Ability to produce either frequency modulated mathematical noise, white noise or pink noise or representative noise of HV installations (noise from broadcasting stations, noise from PLC communications, noise from power electronic (IGBTs, Tryristores, etc.) with controlled characteristics that are electromagnetically coupled to the PD pulses representative of type defects for the superposition of both, to be measured by the instrument under evaluation. Purpose of analyzing the ability of the measuring and diagnostic instrument to eliminate noise and extract the PD pulse signals corresponding to the pulses coming from the defects.
iii. **Ability to generate pulses delayed in time just as their propagation through the grid would:** Ability to generate pulses attenuated, distorted and delayed a time interval equal to that necessary to travel, at the propagation speed of the cable, the length of one of the two cables arranged in the reference testing set-up that corresponds to the distance between the source producing the PD pulses and the sensor of the measuring system under evaluation and qualification that measures them. All this with the purpose of evaluating the error of the measuring system in the evaluation and qualification of its functionalty for determining the position of a source producing PD along a cable.
iv. **Ability to have PD sources on either side of an interconnection boundary between two HV equipment.** Ability to place the terminals of the cells with the type defects in parallel with the insulation of one or another element of the model of the HV testing set-up, specifically in parallel with the cable or in parallel with the cabin module of the referred HV testing set-up. All this with the purpose of evaluating the ability of the PD measuring and diagnostic instrument to identify whether the PD source is on one or the other side of the interconnection border.
v. **Ability to generate several type defects** simultaneously. Ability to simultaneously generate multiple PD sources representative of type defects indicated in point i) by applying HV alternating current or direct current and in ranges of a few kilovolts or by reproducing artificial PD pulses recorded in previous tests. All this with the purpose of evaluating the ability of the PD measuring and diagnostic instrument to separate the different PD sources and evaluate the ability to diagnose the defect or cause causing source of PD pulse generation.

### BRIEF DESCRIPTION OF THE DRAWINGS

To complete the description and in order to help a better understanding of the characteristics of the invention according to a practical embodiment thereof, the following figures are presented accompanying said description, in which by way of illustration and in a non-restrictive manner, the following is presented:
Figure 1.1 shows a flow chart of the method for evaluating and qualifying the functional characteristics of PD measuring and diagnostic instruments in its simplest embodiment.
Figure 1.2 shows a flow chart of the method for evaluating and qualifying the functional characteristics of PD measuring and diagnostic instruments according to a possible embodiment of the invention that comprises the generation of the reference pulses from a synthetic generator.
Figure 2 shows a diagram of the HV testing set-up at reduced scale, that makes it possible to generate series of PD reference pulses and evaluate and qualify the functional characteristics of the measuring instruments, according to a possible embodiment of the invention..
Figure 3 shows the detailed plans of the cabin module in which the module of the set of plug-in and interchangeable cells is adapted,
Figure 4 shows the drawings of the PD measuring module using an IEC60270 sensor and a high frequency current transformer (HFCT) sensor.
Figure 5.a shows the noise signal generation and superposition module.

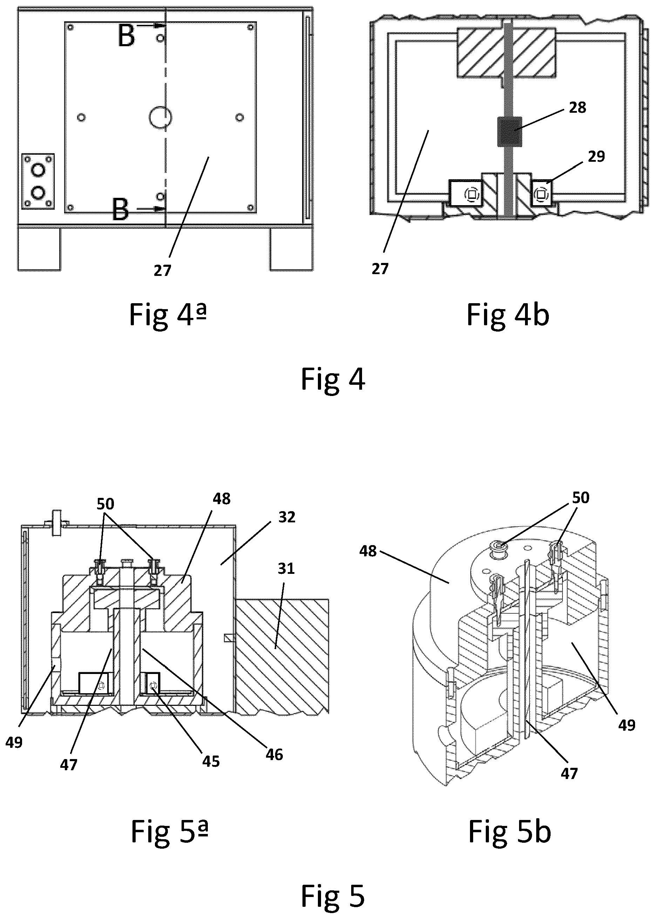

Figure 5.b shows in detail the stage of superposition of noise signals.

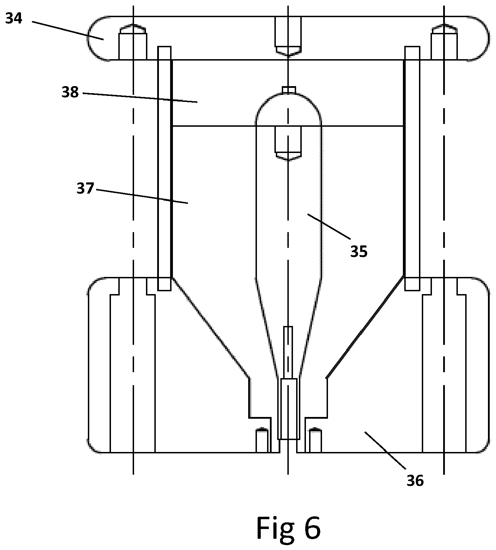

Figure 6 shows the example of a plug-in cell with a cavity-type defect.

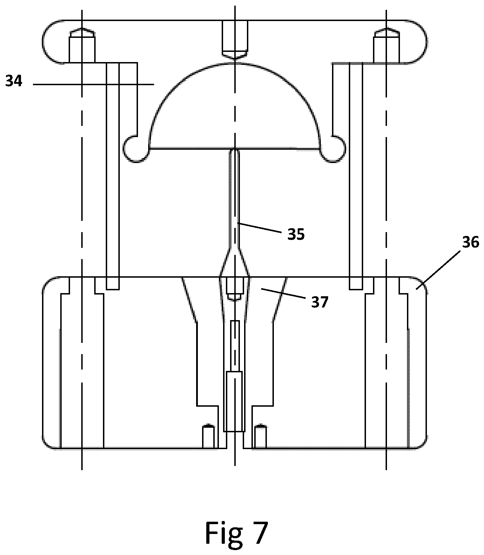

Figure 7 shows the example of a plug-in cell with a corona type defect

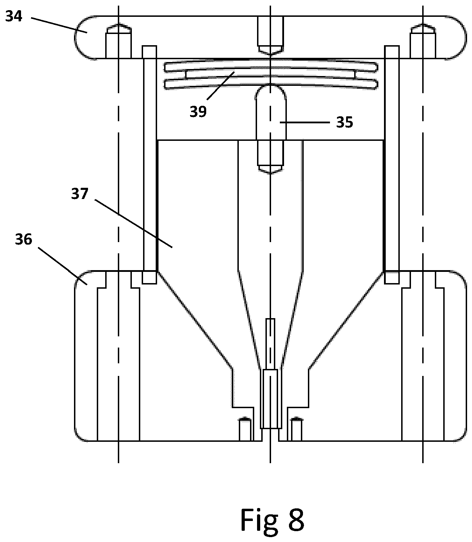

Figure 8 shows the example of a plug-in cell with a surface type defect.

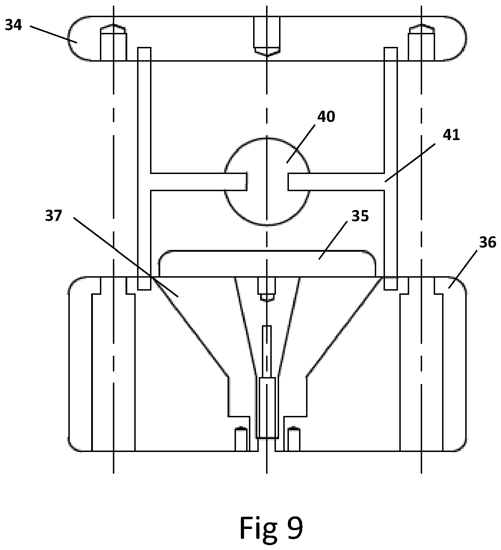

Figure 9 shows an example of a plug-in cell with a type defect of metal part at floating potential

### DESCRIPTION OF A PRACTICAL EMBODIMENT OF THE INVENTION

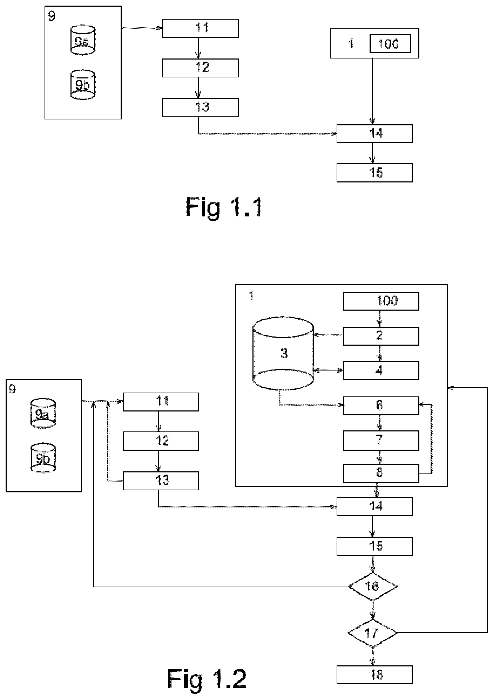

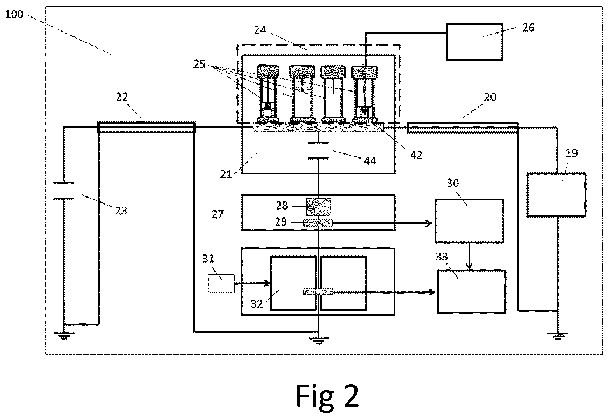

The method for evaluating and qualifying the functional characteristics of PD measuring and diagnostic instruments of the invention comprises, in its simplest embodiment, the following stages (see figure 1.1):
- generation (1) from a scale HV testing setup (100) as shown in figure 2 of at least one PD reference pulse test series related to a electrical defect type representative of HV grids. Most preferably, the series of reference partial discharge pulses are produced in plug-in and independent cells (25) (see figure 2) of the testing setup, each containing a single type defect (in figures 6, 7, 8 and 9 show examples of various plug-in cells (25)), so that any known defect or even any defect that may manifest itself in the future can be tested by designing the appropriate plug-in cell.
- generation of at least one electrical noise signal (9),
- superposition (14) by menas of electromagnetic coupling without galvanic connection of one or more of the generated PD reference pulse series (corresponding to a specific functional characteristic of the measuring and diagnostic instrument for discrete charge values) and of the electrical noise signal or signals generated, and
- Evaluation and qualification (15) of said functional characteristic of the measuring and diagnostic instrument, by supplying the superposition of the signals, to obtain the reading and the diagnosis result of said instrument and compare with the expected values.

A highly preferred variant of the method of the invention has provided that the generation stage (1) of series of reference PD pulses in the HV testing setup (100) can be recorded or stored digitally for standardization purposes, for example, being able to later synthesize it in the form of series of artificial pulses from the information recorded in the absence of the test configuration (100). Since the series of pulses are analog, said preferential variant comprises the digital recording of said series, to enable their analog reproduction as series of artificial pulses without the need to use the HV setting-up, said preferential variant comprising the following sub-stages of the generation (1) (see figure 1.2):
- the raw digitization (2) of each series of reference PD pulses - generated by the testing setup (100) - corresponding to each defect,
- the storage (3) in a database of each series of raw digitized pulses,
- the processing (4) or debugging in real time -for optimized storage (3) in the memory of the database- of each series of PD pulses corresponding to each defect by means of the search, selection and real-time recording of only the samples corresponding to the PD pulses avoiding the recording of all other samples not corresponding to PD pulses, only the digital samples corresponding to the PD pulses being stored in the digital data bank together with the information on the starting time of each pulse of the series with respect to instant zero of the beginning of the test, obtaining a debugged digital data bank, and
- -the analog synthesis (7) of series of artificial PD pulses of interest for evaluating and qualifing the corresponding functional characteristic from the series digitized and stored in the storage stage (3).

This variant of the invention includes another data preparation step (6) by adjusting its amplitude and concatenating by repeating series of shorter reference PD pulses, as many times as necessary until completing the longest series duartion, so that all the series are combined so that they can be reproduced simultaneously in the testing time. This is another advantage of this variant, since due to the digital nature of the stored data we can adjust said amplitude and duration to the most convenient according to the functional characteristic to be evaluated. This stage is preferably carried out before analog synthesis (7), since scaling at the data level is possible and at the level of the analog phenomenon is much more complicated (it would require changes in geometric conditions, materials and pressure, temperature and humidity). Said scaling will have sufficient amplitude to achieve that, in the following stages, the PD pulses arise the appropriate amplitude so that the charge value of the test corresponds to the target charge value during said test; to do this, once the analog synthesis (7) has been carried out with the corresponding digital/analog converter, a PD measurement stage (8) is carried out using a reference instrument, and in case the measured PD amplitude does not correspond to the one of the evaluation and qualification test, the process is fed back, in the data preparation stage (6), to readjust the scaling of the PD digital pulses, which were extracted from the debugged data bank.

The search and selection of the PD pulses and rejection of the non-pulse samples carried out by the processing (4) of the raw digitized signals, the method of the invention has foreseen that it is ideally carried out by:
- identification of the starting instant of the pulses in each series by means of a DP filter based on the wavelet transform processed with multiprocessors or an FPGA, and
- -Recording of the pulse for a time between 1 and 2 µs from that instant (preferably 2 µs), since it offers sufficient precision for the identification of the pulse in such a way that the necessary recording time is very small, lightening storage requirements. With this same purpose, and in order to achieve a good synthesis of the artificial pulses after their digitization, it has been foreseen that the digitization is carried out with a temporary definition of up to 5 ns and a vertical resolution of at least 16 bits.
With this variant, the advantage is obtained of being able to store the important information of the pulse series with very light memory requirements, obtaining as additional or unexpected advantages a practical portability thanks to the synthetic generation of a series of artificial PD pulses representative of type defects that can be reproduced in any site and place, which allows to carry out onsite instrument evaluations, just before a measurement in the field; Furthermore, very unexpectedly in principle, the possibility of scaling the artificial PD pulses to adapt their amplitude to the needs of the evaluation and qualification to be carried out without loss of quality has been obtained.

Likewise, the possibility that the portable generator can generate artificial synthetic pulses of different types of defects allows to promote the development of clustering algorithms to separate different sources of PD generation, to identify the directionality of the pulses, as well as for localization of PD sources.

Furthermore, this version of the generation of reference PD pulse series by means of the synthesizer makes it possible to leave out the HV setting-up from which they were recorded, since the analog pulses can be artificially generated in a D/A converter, from its version stored in digital format, which means that, in laboratories, researching centers and training centers, it is not necessary to work with HV setting-up to generate the series of PD pulses. Going into detail regarding the generation stage of at least one electrical noise signal (9), said stage ideally comprises (see Figures 9a and 9b):
- a first sub-stage (9) for generating a primary digital noise signal from an arbitrary function generator (9a) or from a database of digital noise files (9b),
- a second sub-stage (11) for data preparation in amplitude and scaling of the primary digital noise signal, in the corresponding proportion during the same time period as the PD pulse test series, obtaining a prepared digital signal,

- a thrid sub-stage (12) to convert the prepared digital noise signal to analog continuous noise (12) during the same time period as the one of the PD pulse testing series, by means of using an aditional D/A converter,
- the measurement (13) of the noise signal using a reference instrument, and in the event that the measured amplitude does not correspond to the one of the evaluation and qualification test, it is fed back by readjusting the scaling of the prepared digital signal.

Said signals for generating electrical noise can be for example:
- white noise signals,
- pink noise signals,
- PLC communication noise signals,
- noise signals modulated at fixed frequencies, and
- pulsing noise signals from power electronics.

To carry out a truly reliable evaluation and qualification (15), it would be convenient to carry out successive generation stages (1) of the series of PD pulses used, increasing their charge value by a discrete percentage with respect to the range limit objective of evaluation and qualification, until covering the charge limits object of verification (17), and covering the limits of superimposed noise (16) in the verification of the effectiveness of the instrument to be evaluated, to obtain a curve of the functional characteristic (18) as a function of the variable electrical noise. This is very easy to do in the synthetic generation version using artificial reference pulses, so these stages are implemented in it as shown in figure 1.2, which is an additional advantage of it. In the version using the test setting-up (100) it would be extraordinarily complex, so that in figure 1.2 these successive generation stages are not reflected, obtaining a correct evaluation (15) in discrete charge values.

Therefore, if during the evaluation and qualification, the result of a measurement and diagnosis of the instrument to be evaluated related to the specific functional characteristic has been unfavorable, the method foresees the reduction of the prepared digital noise signal in a percentage of the amplitude of the PD pulses of the applied series of pulses and the repetition of the test until said evaluation is favorable, obtaining at that time the threshold of the searched functional characteristic (sensitivity, identification of the defect type, discrimination of PD sources, directionality of PD pulses, defect location error.)

Specifically, for the evaluation and qualification of each specific functional characteristic of the measuring and diagnostic instrument, the invention method comprises the use (and therefore prior generation) of one or more of PD pulses series associated with one or more type defects selected from the following:
- internal cavity in a solid insulation,
- defect in a cable at a certain distance from the PD measuring sensor.
- defect in surface insulation exposed to ambient air,
- false contact,
- metallic part at floating potential in air,
- corona in air,
- corona in oil,
- defect in a surface insulation in oil,
- defect in a surface insulation in SF6,
- corona in SF6,
- floating particles in SF6.

On the other hand, among the most important functional characteristics that can be evaluated by means of the operations of the invention method are included:
- detection sensitivity of a type of defect versus noise,
- ability to associate a source of PD pulse generation with a type of electrical defect, versus electrical noise conditions,
- ability to separate different sources of PD generation measured with a single sensor versus electrical noise conditions,
- Ability to identify where the PD pulses come from when detected by a single sensor located at the border ground connection between two devices versus electrical noise conditions, and
- location error expressed in meters of a PD source along a cable measured with one or two high-frequency sensors versus electrical noise conditions.

As an example, mention that the evaluation and qualification of the functional characteristic of detection sensitivity of a type of defect versus noise would include:
a) choose a series of PD pulses of a standard defect selected from:
   - PD pulses from a cavity type defect in a solid insulation,
   - PD pulses from a false contact type defect,
   - PD pulses from a surface discharge type defect in oil,
   - PD pulses from a floating particle type defect in SF6, and
b) choose a charge level for the selected series
c) Decrease the level of the prepared digital noise signal by a percentage of the PD pulse amplitude until the equipment is sensitive to the series of pulses corresponding to a type of defect, for example by analyzing its PD pattern.
d) repeat the process for another lower charge value up to the maximum sensitivity.

The evaluation and qualification of the functional characteristic of the ability to associate a source that generates PD pulses with a type of electrical fault under electrical noise conditions would include:
a) choose one or more series of standard defect PD pulses selected from:
   - PD pulses from a cavity type defect in solid insulation,
   - PD pulses from a corona defect in air,
   - PD pulses from a surface type defect in the air,
   - PD pulses from a metal part defect at floating potential,
   - PD pulses from a false contact type defect,
   - PD pulses from a surface discharge type defect in oil
   - PD pulses from a floating particle type defect in SF6, and
b) choose a load level for the chosen series
c) Decrease the level of the prepared digital noise signal by a percentage of the PD pulse amplitude until the equipment is able to associate the series of PD pulses with the correct type of defect.
d) repeat the process for another lower charge value up to the maximum sensitivity.

The evaluation and qualification of the functional characteristic of the ability to separate different sources of PD generation measured with a single sensor versus electrical noise conditions would include:
a) choose the following four series of PD pulses of type defect:
   - PD pulses from a cavity type defect in a solid insulation,
   - PD pulses form a corona defect in air,
   - PD pulses from a false contact type defect,
   - PD pulses form asurface type defect in air, and
b) choose a charge level for the selected series
c) Gradually scale the noise amplitude until the instrument is able to separate PD sources by groups showing their representative patterns, even if it had not correctly identified each source with the corresponding type defect.
d) repeat the process for another lower charge value up to the maximum sensitivity.

The evaluation and qualification of the functional characteristic of the ability to identify where the PD pulses come from when detected by a single sensor located at the border ground connection between two equipment versus electrical noise conditions would be applicable only to equipment that is capable of indicating the directionality of PD pulses when they are measured by a high current transformer type sensor located at the border ground connection between two HV equipment, and would include:
a) choose PD pulses forma a cavity type defect in a solid insulation,
b) choose a charge level for the selected series
c) Decrease the leve lof the prepared digital noise signal by a percentage of the amplitude of the PD pulses until the equipment is able to identify where the PD pulses come from.
d) repeat the process for another lower charge value up to the maximum sensitivity.

And the evaluation and qualification of the functional characteristic of evaluating the location error expressed in meters of a PD source along a cable measured with a single high-frequency sensor versus electrical noise conditions, which is applicable only to the instrument that is capable of automatically indicating the position of a defect along a cable applying reflectrometry if they only use a single PD measuring sensor or those that use the flying time criterion if they use two PD measuring sensors , would include:
a) if a single sensor is used, choosing a series of cavity-type defect PD pulses along the cable located at a known distance x from one of the measuring sensors for which the evaluation and qualification of the functional characteristic is desired to be carried out.
b) If two sensors are used, to choose two series of cavity-type defect PD pulses along the cable located at a known distance x from one of the measuring sensors for which the evaluation and qualification of the functional characteristic is desired to be carried out,
c) choose a charge level for the selected series,
d) gradually scale the noise amplitude until the instrument is able to determine the position of the defect along the cable.
e) repeat the process for another lower charge value up to the maximum sensitivity.

In the event that the instrument to be evaluated uses a single sensor, a series of PD pulses corresponding to "defect in a cable located at a distance x from the measuring sensor" is chosen from the reference PD series digital file bank. In this type of series, each PD event is recorded in the series at two different times. The delayed time between the two pulses in the series corresponds to the time difference that a PD pulse requires to reach the sensor in these two directions: the distance x between the defect and the sensor traveling directly, and traveling in the opposite direction to the open cable end (I-x), subsequently traveling the entire length of the cable I until it reaches the sensor, that is 2·I-x.

In the event that the instrument to be verified uses two sensors, two series of PD pulses are chosen corresponding to "defect in a cable located at a distance x from one of the two measuring sensors and (I-x) from the other" are chosen from the reference PD series digital files bank. In these two series, each PD event is recorded with different delayed times. The exact delayed time between the pulses recorded in one series and in another corresponds to the time difference required for a PD pulse to reach one sensor and the other, (the distance x between the defect and one of the sensors traveling directly, and in opposite direction the distance I-x between the defect and the other sensor).

Regarding the setting-up to generate the series of reference pulses, it can be a scale HV testing setup (100) (see figure 2) of a few KV to generate series of reference pulses of the partial discharge type (PD), or said series of pulses, always originally generated in said testing setup (100), can be synthesized by means of digital storage, processing or debugging and digital storage for generation by analogization according to the method of the invention.

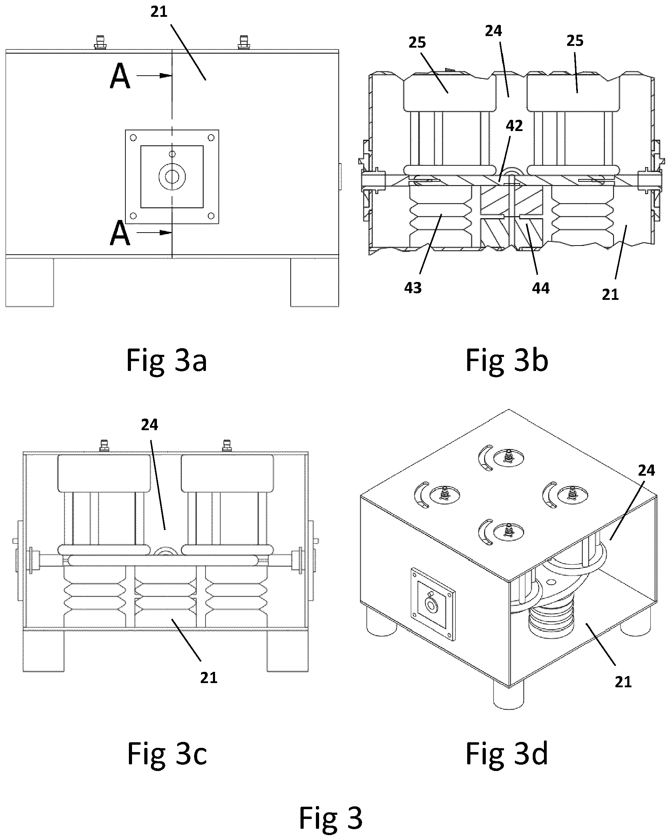

Specifically, the test facility (100) comprises in its most basic version:
- an adjustable AC or DC voltage generation module (19) (a few kilovolts) to simulate the grid generation source,
- a power cable (20) of known characteristics that connects to the voltage generation module (19),
- a cabin module (21) (see figure 3) connected to the power cable (20), comprising an HV plate (42) isolated from a metallic envelope by three insulators (43) and a capacitor (44), to simulate the capacitance of the insulation with respect to the metal enclosure of an installation,
- An electrical grid module (return to figure 2) comprising an isolated HV cable (22) to simulate the power cable of the transmission or distribution grid interconnected to the cabin module and a capacitor (23) that simulates the continuity of the isolated lines of the grid,
- a module for generating series of reference PD pulses (24), which is connected to the HV plate (42) of the cabin module (21), and which comprises a set of plug-in cells (25) of type defects connected all of them to the HV plate but leaving free each of their grounding connections,
- a first PD measuring module (26) arranged at the origin where they occur,
- a second measuring module (27) of the charge of the series pulses (see figure 4) by means of the normative method (IEC 60270) (28) and by means of a high frequency current transformer,
- an electrical noise signal generation module (31),
- a superposition module (32) of the electrical noise signal generated with the series of reference PD pulses generated (see figure 5), to be applied said superposition to the measuring and diagnostic instrument (33).

In order to be able to record and synthesize the series of artificial PD pulses, the setting-up would also include in a preferred version:
- a DP pulse recorder -in memory-optimized- and PD pulse player-back module (30) (see figure 2) comprising an analog/digital converter for converting the series of analog pulses from PD to digital format, taken from digital storage for temporary and definitive storage of digitized pulse series, and a digital/analog conversion module to synthesize artificial analog pulse series from those stored in digital format,
- a filter, not shown, of noise and detection of PD based on the wavelet transform processed either with multiprocessors or in an FPGA to identify in real starting instant of the pulse of a PD, and
- a timer, not shown, to determine a defined time for recording the pulses of a series of PDs from the detection of their start.

Ideally, the DP pulse recorder and player-back module (30) and the electrical noise generation module (31), are removable from the setting-up, and portable to be able to record and reproduce analogically the series of stored pulses and characteristic noises to be superimposed, at different locations without any need of ussing the HV testing setup. The analog/digital converter and the digital/analog conversion module ideally have equal time definition values of 5 ns or 10 ns and vertical resolution of 16 bits at least, and both the DP pulse recorder/player-back module (30) as the electrical noise generation module (31), they preferably include scalers and amplifiers, not shown, to adapt the amplitude of the series of pulses and of the noise signal generated.

For its part, each of the cells (25) (see figure 2) that generates a series of reference PD pulses comprises (see figures 6 to 9) an HV electrode (34) in the shape of a circular disk connected to the plate of the cabin module, a rod-shaped electrode (35) facing the HV electrode, in which the PD pulses are captured, and a grounding electrode (36), which can be connected to one of the following two grounds: screen of the output cable module (22) or to the metal enclosure of the cabin module (21) in order to analyze the ability of the measuring and diagnostic instrument to detect directionality of the pulses.

For example, it is possible to configure a plug-in cell that generates a reference PD of internal defect in an isolation (figure 6), which comprises the rod-shaped electrode (35) terminated in the shape of a hemispherical cap, in which for the range of test voltages the electric field at the tip of the hemispherical cap is of the order of 3 to 5 kV / mm, providing in the area of the hemispherical cap of the rod an insulating polyethylene base (37) that acts as a separator and to support the cylindrical solid insulation samples to be tested (38), in which a hole is made. in the form of a hemispherical cap so that the electrode adapts, and a laminar cavity in the deepest part of the interior of the hemispherical concave part, so that the PD pulses are produced between the hemispherical cap of the electrode and the insulating surface of the testing sample.

Another possible plug-in cell would be to generate reference PD of corona-type defect in air (figure 7), which would comprise the upper aluminum electrode (34) with a spherical semi-cap shape to which the AT is applied, a rod metal (35) of small radius, insulated and shielded by the ground electrode (36) by means of an insulating base of polyethylene (37) that acts as a separator and a free distance in air between the upper spherical semi-cap and rod.

Another possible plug-in cell would be to generate reference PD of surface type defect in air (figure 8), which would comprise an HV upper plate (34), one or more plate-type insulating discs (39), a lower electrode (35) formed by a rod finished in a hemisphere in which the PD pulses are produced and captured and the grounding electrode that acts as a guard (36) separated from the rod by a polyethylene insulator (37) that acts as a separator.

Another possible plug-in cell would be to generate reference PD of a floating metal part type defect in air (figure 9), which would comprise two aluminum plates, one of them connected to HV (34), another that acts as a pick-up sensor (35), separated from the grounding electrode (36) by a polyethylene insulator (37) that acts as a separator. It also has a metal element with floating potential (40) fixed on a surface of insulating material (41), adjustable in terms of distance to both plates.

As for the PD measuring module (27), it preferably comprises a conventional PD meter (according to the IEC 60270 standard) to measure the current pulses that circulate through an measuring impedance, and a high frequency current transformer (HFCT) (28) whose output signals are recorded by the recording and playback module (30).

The electrical noise signal generation module (31) could comprise an arbitrary generator of functions for the generation of white noise, pink noise, or modulated noise (9a) or a database of digital noise files representative of electrical installations (9b).

The superposition module (32) of the electrical noise signal generated with the series of generated reference PD pulses, in order to apply said superposition to the PD measuring and diagnostic instrument to be evaluated, preferably comprises (see figure 5):
- a high-frequency current transformer (45) through its secondary both signals (noise and PD pulses) are coupled to be supplied to the diagnostic instrument to be evaluated (33),
- two galvanically separated current loops (46) and (47) passing through the core of the transformer, arranged inside a mixing device, and
- a coaxial enclosure made of non-ferromagnetic material divided into an upper enclusure (48) and a lower enclosure (49) pluggable together; the upper enclosure comprising four connectors (50) to inject through its central tube the electrical noise to be mixed with the PD pulses.

While the adjustable AC or DC voltage generation module (19) preferably comprises (these elements are not represented as this configuration is known):
- an autotransformer, with which the AC voltage is regulated,
- a transformer to increase the voltage with a rated power of a few hundred VA (e.g. 500 VA),
- a DC rectifier circuit of a few kV (e.g. 18 kV), and
- a blocking filter to prevent the DPs from leaking through the power supply and viceversa, that the possible DPs generated by the HV source affect the reference generator.

Having sufficiently described the nature of the invention, as well as the way it is carried out in practice, it should be noted that the provisions indicated above and represented in the attached drawings are susceptible to detailed modifications as long as they do not alter the fundamental principle.

### ACKNOWLEDGMENTS

""The technical development that has led to this application has received funding from the EMPIR program co-financed by the Participating States and from the European Union's Horizon 2020 Research and Innovation Program"

## Claims

1. Method for evaluating and qualifying the functional characteristics of PD measuring and diagnostic instruments that it comprises the following stages:
- generation (1) from a HV testing setup (100) to scale of at least one PD reference pulse test series related to a type of electrical defect representative of HV grids,
- generation of at least one analogic signal of electrical noise from a digital signa lof electrical noise,
- superposition (14) by means of an electromagnetic coupling without galvanic connection of one or more of the series of generated PD reference pulses corresponding to a specific functional characteristic of the measuring and diagnostic instrument for discrete values of chage and for the generated electrical noise signal(s), and
- evaluation and qualification (15) of said functional characteristic of the measuring and diagnostic instrument, supplying it with the superposition by means of the signals to obtain the reading and the result of the diagnosis of said instrument and compare with the expected values;
**characterized in that** the stage of generating at least one electrical noise signal comprises:
- a first sub-stage (9) for generating a primary digital noise signal from an arbitrary function generator (9a) or from a database of digital noise files (9b),
- a second sub-stage (11) for data preparation in amplitude and scaling of the primary digital noise signal, in the corresponding proportion during the same time period as the PD pulse test series, obtaining a prepared digital signal,
- a thrid sub-stage (12) to convert the prepared digital noise signal to analog continuous noise (12) during the same time period as the one of the PD pulse testing series, by means of using an aditional D/A converter,
- the measurement (13) of the noise signal using a reference instrument, and in the event that the measured amplitude does not correspond to the one of the evaluation and qualification test, it is fed back by readjusting the scaling of the prepared digital signal.

2. Method for evaluating and qualifying the functional characteristics of PD measuring and diagnostic instruments according to claim 1 charcaterized in that the series of partial discharge reference pulses are produced in plug-in and independent cells (25) of the testing setup, each containing a single type defect.

3. Method for evaluating and qualifying the functional characteristics of PD measurement and diagnostic instruments according to any of the previous claims **characterized in that** the generation stage (1) of series of reference PD pulses in the HV testing setup (100) comprises that the series of geenrated reference PD pulses in the HV testing setup (100) can be digitally recorded or stored for playback in the absence of the testing setup (100) using the following sub-stages:
- the raw data digitization (2) of each series of reference PD pulses generated by the testing setup (100), corresponding to each defect,
- the storage (3) in a database of each series of raw digitized pulses,
- the processing (4) in real time for optimized storage (3) in memory of the database of each series of PD pulses corresponding to each defect by searching, selecting and recording in real time only the digital samples corresponding to the PD pulses, only the digital samples corresponding to the PD pulses being stored in the digital data bank, together with the information on the starting time of each pulse in the series with respect to the zero starting time of the test, and
- the analog synthesis (7) of several series of artificial PD pulses of interest for evaluating and qualifying of the corresponding functional characteristic from the series digitized and stored in the storage stage (3);
where the searching, selection and recording in real time of the digital simples corresponding to PD pulses is made by means of:
- identification of the starting instant of the pulses in each series by means of a DP filter based on the wavelet transform, and
- -Recording of the pulse for a time between 1 and 2 µs from that instant;
An where the digitization of the series of the PD pulses is carried out with a temporary definition of 5 ns or 10 ns and a vertical resolution of at least 16 bits.

4. Method for evaluating and qualifying the functional characteristics of PD measuring and diagnostic instruments according to claim 3, **characterized in that** the analog synthesis (7) of the series of digitally recorded PD artificial pulses of interest for evaluatiing and qualifying the corresponding functional characteristic comprises a data preparation step (6) by adjusting its amplitude and concatenating by repetition of shorter reference PD pulse series to complete a longer series duration.

5. Method for evaluatiing and qualifying the functional characteristics of PD measuring and diagnostic instruments according to any of the preceding claims, **characterized in that** it comprises successive stages of generation (1) of the series of PD pulses used increasing their charge value in a discrete percentage with respect to the limit of the range objective of verification (17), until reaching the extreme value of the charge objective of verification to obtain the curve of the functional characteristic (18) versus the electrical noise variable.

6. Method for evaluating and qualifying the functional characteristics of PD measuring and diagnosis instruments according to any of the previous claims, **characterized in that** if the result of the measurement and diagnosis of the instrument to be evaluated versus the specific functional characteristic has been unfavorable for a charge level, the level of the prepared digital noise signal is decreased by a percentage of the amplitude of the PD pulses of the applied series and the test is repeated until said evaluation is favorable to obtain the sought threshold of the characteristic functional for different charge levels.

7. Method for evaluating and qualifying the functional characteristics of PD measuring and diagnostic instruments according to any of the preceding claims, **characterized in that** the evaluation and qualification of each specific functional characteristic of the measuring and diagnostic instrument comprises the use of one or more series of PD pulses associated with one or more type defects selected from the following:
- internal cavity in solid insulation,
- defect in a cable at a certain distance from the sensor,
- defect in surface insulation exposed to ambient air,
- false contact,
- metallic part at floating potential in air,
- corona in air,
- corona in oil,
- defect in surface insulation in oil,
- defect in surface insulation in SF6,
- corona in SF6,
- floating particles in SF6.

8. Method for evaluating and qualifying the functional characteristics of PD measurement and diagnostic instruments according to any of the preceding claims, where the noise signal (11) is generated by an arbritary function generator (9a) from mathematical noise, white noise, pink noise, or from files stored in a database of digital noise files (9b) and corresponding to noises acquired in HV facilities.

9. Method for evaluating and qualifying the functional characteristics of PD measuring and diagnosis instruments according to any of the previous claims, where the functional characteristics to be evaluated are selected from the following:
- sensitivity of detection of a type of defect versus noise,
- ability to associate a source that generates PD pulses with a type of electrical fault, in the face of electrical noise conditions,
- ability to separate different sources tha generate PD pulses measured with a single sensor versus electrical noise conditions,
- ability to identify where the PD pulses come from when they are detected by a single sensor located at the border ground connection between two devices, in the face of electrical noise conditions, and
- location error expressed in meters of a PD source along a cable measured with one or two high-frequency sensors, under electrical noise conditions.

10. Installation to generate series of PD reference pulses **characterized in that** it comprises:
- an adjustable AC or DC voltage generation module (19) (a few kilovolts) to simulate the grid generation grid,
- a feeding cable (20) of known characteristics that connects to the voltage generation module (19),
- a cabin module (21) (see figure 3) connected to the power cable (20), comprising an HV plate (42) isolated from a metallic envelope by three insulators (43) and a capacitor (44), to simulate the capacity of the insulation with respect to the metal enclosure of an installation,
- An electrical grid module comprising an isolated HV cable (22) to simulate the power cable of the transmission or distribution grid that interconnects the cabin module and a capacitor (23) that simulates the continuity of the isolated lines of the grid,
- A module for generating series of reference PD pulses (24), which is connected to the HV plate of the cabin module (21), and which comprises a set of plug-in cells (25) of type defect connected all of them to the AT plate but leaving each of its grounding connections free,
- a first PD measuring module (26) arranged at the origin where it occurs,
- a second measuring module (27) to measure the charge of the series pulses (see figure 4) by means of the normative method (IEC 60270) (28) and a second measuring device (29) by means of a high-frequency current transformer,
- an electrical noise signal generation module (31),
- a superposition module (32) of the generated electrical noise signal generated with the series of reference PD pulses(see figure 5), to be applied said superposition to the measuring and diagnostic instrument (33);
**characterized in that** the superposition module comprises:
- a coaxial enclosure made of non-ferromagnetic material divided into an upper enclusure (48) and a lower enclosure (49) pluggable together; the upper enclosure comprising four connectors (50) to inject the electrical noise to be mixed with the reference PD pulses.
- two separated current loops (46) and (47) passing through the core of the high frequency transformer (45), for electromagnetic coupling, without galvanic connection, the electrical noise to the serires of the PD pulses.
- a high frequency current transformer (45) arranged in a mixing device, so that both signals (noise and PD pulses) are coupled to be fed to the diagnostic instrument to be evaluated (33),
